(19) Europäisches Patentamt
European Patent Office
Office européen des brevets

(11) **EP 1 852 969 A1**

(12) **EUROPEAN PATENT APPLICATION**
published in accordance with Art. 158(3) EPC

(43) Date of publication:
**07.11.2007 Bulletin 2007/45**

(51) Int Cl.:
*H03B 5/18* (2006.01)

(21) Application number: **06712885.0**

(22) Date of filing: **02.02.2006**

(86) International application number:
**PCT/JP2006/301742**

(87) International publication number:
**WO 2006/085470 (17.08.2006 Gazette 2006/33)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **10.02.2005 JP 2005033734**

(71) Applicant: **KABUSHIKI KAISHA KOBE SEIKO SHO Kobe-shi, Hyogo 651-8585 (JP)**

(72) Inventors:
• **KEGASA, Koyo**
**c/o KABUSHIKI KAISHA KOBE SEIKO SHO Kobe-shi, Hyogo 6512271 (JP)**

• **MANABE, Chitaka**
**c/o K. K. KOBE SEIKO SHO Kobe-shi, Hyogo 6512271 (JP)**

(74) Representative: **Charlton, Peter John Elkington and Fife LLP Prospect House 8 Pembroke Road Sevenoaks Kent TN13 1XR (GB)**

(54) **NEGATIVE RESISTANCE INPUT AMPLIFIER CIRCUIT AND OSCILLATION CIRCUIT**

(57) The present invention provides a negative resistance input amplifier including: a microstrip line having one end connected to a collector of a transistor and the other end being open with a length of 1/4 of a wavelength λ at a predetermined frequency f; and a microstrip line having one end connected to an emitter of the transistor and the other end grounded with a length of 1/4 of the wavelength λ at the predetermined frequency f so that impedance viewed from a base of the transistor becomes negative only at around a target frequency, and an oscillator using the negative resistance input amplifier.

FIG. 1

Printed by Jouve, 75001 PARIS (FR)

## Description

Technical Field

The present invention relates to a negative resistance input amplifier circuit having the input impedance that is negative with respect to a signal of a predetermined frequency, and an oscillation circuit using the same.

Background Art

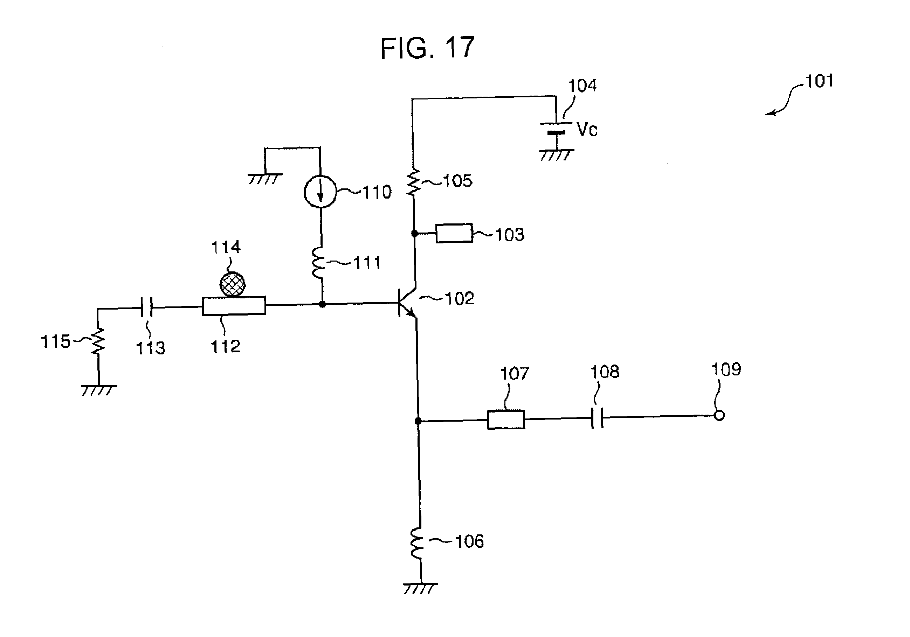

FIG. 17 is a circuit diagram showing the configuration of an oscillation circuit of the background art (see Patent Document 1, for instance). An oscillation circuit 101 of FIG. 17 is a microwave oscillator circuit that generates a microwave, and includes an NPN transistor 102, a microstrip line 103 having one end connected to the collector of the transistor 102 with a length of 1/4 of a wavelength $\lambda$ at an oscillation frequency f of the oscillation circuit 101, and the other end being open, a DC voltage source 104 outputting a DC voltage Vc, and a resistor 105 connected between the collector of the transistor 102 and a voltage output terminal of the DC voltage source 104. Further, the emitter of the transistor 102 is grounded through a coil 106, and a signal output from the emitter of the transistor 102 is output to an external output terminal 109 through a microstrip line 107 and a DC-blocking capacitor 108.

Further, the transistor 102 has a base supplied with a bias current from a constant current source 110 through a coil 111. Further, the transistor has the base thereof grounded through a microstrip line 112, a DC-blocking capacitor 113, and a resistor 115, and the microstrip line 112 is coupled to a dielectric resonator 114.

It has been known that, in the thus-configured oscillation circuit 101, the transistor 102 functions as a collector and, if the impedance viewed from the emitter of the transistor 102 is adjusted, the input impedance viewed from the base of the transistor 102 is negative with respect to an RF signal due to an influence of a parasitic capacitance in the transistor 102. Such an amplifier circuit in which the input impedance is negative is called a negative resistance input amplifier circuit.

Further, the microstrip line having a length of $\lambda$/4 with respect to a signal having the wavelength $\lambda$ has been known to function as the impedance converter for the signal having the wavelength $\lambda$. To be specific, it has been known that, in the microstrip line having an output terminal open with a length of $\lambda$/4 with respect to the signal having the wavelength $\lambda$, its impedance is substantially zero with respect to the ground potential, that is, the line appears to be grounded with respect to the signal having the wavelength $\lambda$ as viewed from an input terminal. In contrast, the microstrip line having an output terminal grounded with a length of $\lambda$/4 appears to be open with respect to the signal having the wavelength $\lambda$ as viewed from an input terminal.

Then, if a resistor having the impedance that is 1/2 of the characteristic impedance of the microstrip line is connected to an output terminal of the microstrip line having a length of $\lambda$/4, its resistance appears to be twice as high as the characteristic impedance of the microstrip line as viewed from the input terminal. Further, it has been known that if a resistor having the impedance that is twice the characteristic impedance of the microstrip line is connected to an output terminal of the microstrip line having a length of $\lambda$/4, its resistance appears to be 1/2 of the characteristic impedance of the microstrip line as viewed from the input terminal.

Next, an operation of the oscillation circuit 101 of the background art is described. First, the microstrip line 103 has a length of $\lambda$/4, and its end is open, so the line is grounded with respect to an oscillation frequency f of the wavelength $\lambda$ of the oscillation circuit 101. That is, a collector of the transistor 102 is grounded with respect to the oscillation frequency f by the microstrip line 103. Further, the coil 106 and the microstrip line 107 have a high impedance with respect to the oscillation frequency f. Thus, the collector of the transistor 102 is grounded with respect to the oscillation frequency f, and the impedance viewed from the emitter of the transistor 102 appears to be high, with the result that the input impedance at the base of the transistor 102 is negative, and the transistor 102 functions as a negative resistance input amplifier circuit.

On the other hand, as for a signal having a frequency shifted from the oscillation frequency f, the impedance of the microstrip line 103 increases, and the obtained circuit is not a collector-grounded circuit, so the input impedance of the base of the transistor 102 is not negative.

Next, a signal applied to the base of the transistor 102 is reflected to the microstrip line 112 due to the input impedance of the base of the transistor 102. More specifically, if the input impedance of the base of the transistor 102 is positive, a reflected wave has an amplitude smaller than that of an incident wave. If the input impedance of the base of the transistor 102 is negative, a reflected wave has an amplitude larger than that of an incident wave.

Then, the wave reflected by the base of the transistor 102 is reflected to the base of the transistor 102 by the dielectric resonator 114 again, and the reflected wave reciprocates between the base of the transistor 102 and the dielectric resonator 114. A coupling position between the dielectric resonator 114 and the microstrip line 112 is determined such that the phase of the reflected wave from the base of the transistor 102 matches the phase of the reflected wave from the dielectric resonator 114 at the base position of the transistor 102 (phase shift is a multiple of 360°).

As a result, if a reflection gain of the transistor 102 is larger than a reflection attenuation in the dielectric resonator 114, that is, if the input impedance of the base of the transistor 102 is negative and its reflection gain is larger than a reflection attenuation in the dielectric resonator 114, a signal amplitude of the reflected wave is gradually amplified and oscillations occur.

In this case, the input impedance of the base of the transistor 102 is negative if the signal wavelength is $\lambda$, that is, the signal frequency is f, so the oscillation circuit 101 oscillates with the frequency f, and the signal having the signal frequency f is output from the external output terminal 109 through the emitter of the transistor 102, the microstrip line 107, and the capacitor 108.

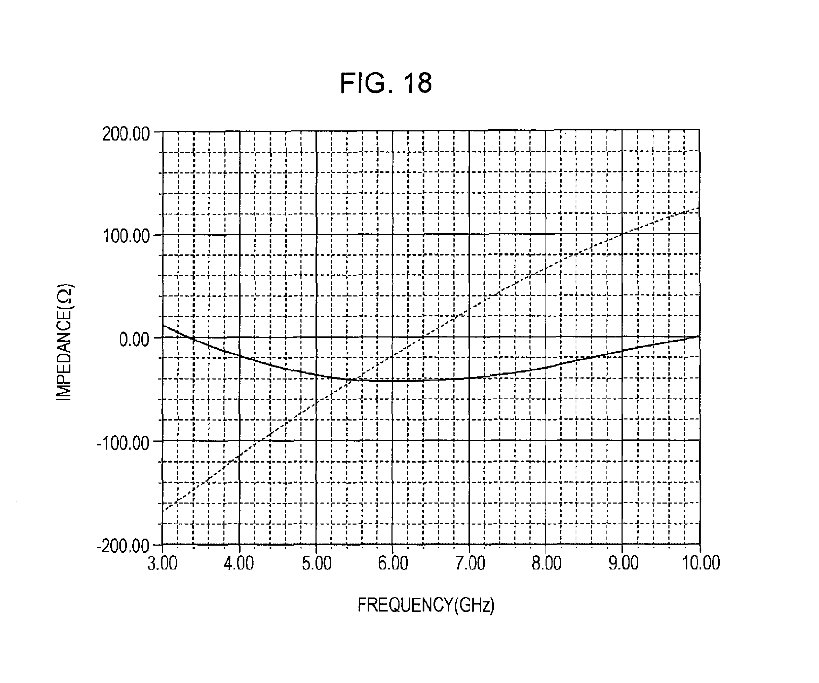

Incidentally, in the above oscillation circuit 101, the input impedance of the base of the transistor 102 is negative over a frequency range of 1 octave or more. FIG. 18 is a graph showing a result of simulating a relationship between the frequency of a signal input to the base of the transistor 102 in the oscillation circuit 102 and the input impedance of the base of the transistor 102. This simulation uses 2SC5508 as the transistor 102, the microstrip line 103 having a width of 1.2 mm and a length of 8 mm, the DC voltage Vc of 3 V, the resistor 105 of 100 Ω, the coils 106 and 111 of 100 μH, the microstrip line 107 having a width of 1.2 mm and a length of 12 mm, the capacitor 108 of 1000 pF, and the constant current source 110 having an output current of 100 μA. Incidentally, as a simulator, Ansoft Designer available from Ansoft Japan K.K. is used. The same conditions are applied to any simulator used for subsequent simulation.

In FIG. 18, the horizontal axis represents the frequency of a signal input to the base of the transistor 102, the vertical axis represents the input impedance of the base of the transistor 102, the solid line represents the real part of the impedance, and the broken line represents the imaginary part of the impedance. As shown in FIG. 18, in the oscillation circuit 101 of FIG. 17, the real part of the input impedance of the base of the transistor 102, that is, the input impedance of a negative resistance input amplifier circuit composed of the transistor 102 becomes negative over a frequency range of 1 octave or more, 3.33 GHz to 9.78 GHz. This causes a problem that the circuit might oscillate with a frequency different from a target oscillation frequency f (6.24 GHz). Patent Document 1: Japanese Unexamined Patent Application Publication No. 2004-7125

Disclosure of Invention

The present invention has been accomplished in view of the above problem. It is accordingly an object of the present invention to provide a negative resistance input amplifier circuit capable of narrowing a frequency range where the input impedance is negative, and an oscillation circuit using the same.

To describe representative ones of the inventions disclosed in this application in brief, a negative resistance input amplifier circuit includes: a transistor; a first microstrip line having a length of 1/4 of a wavelength of a signal having a predetermined frequency, and having one end connected to a collector of the transistor and the other end open; a first resistor connected between the collector of the transistor and a preset first potential; and a resonant circuit connected between an emitter of the transistor and a second potential lower than the first potential, and having the impedance that is highest with respect to a signal of the frequency, wherein a base of the transistor is used as a signal input for receiving a signal from the outside, and the emitter of the transistor is used as a signal output for outputting a signal to the outside.

That is, according to the thus-configured negative reference input amplifier circuit, the collector of the transistor is grounded with respect to a predetermined frequency by the first microstrip line, and the impedance of the emitter of the transistor is maximized with respect to the frequency by the resonant circuit, so the collector of the transistor is grounded and the impedance of the emitter is maximized, whereby a frequency range where the input impedance of the base of the transistor becomes negative can be narrowed.

Brief Description of the Drawings

FIG. 1 is a circuit diagram demonstrating a configuration example of an oscillation circuit according to a first embodiment of the present invention.

FIG. 2 is a graph showing a result of simulating a relationship between a frequency of a signal input to a base of a transistor in the oscillation circuit of FIG. 1 and the input impedance of the base of the transistor.

FIG. 3 is an explanatory view of a microstrip line equivalently representing an influence of a land of a simulation capacitor.

FIG. 4 is a circuit diagram of a modified example of the oscillation circuit of FIG. 1.

FIG. 5 is a graph showing a result of simulating a relationship between a frequency of a signal input to a base of a transistor in the oscillation circuit of FIG. 4 and the input impedance of the base of the transistor.

FIG. 6 is a circuit diagram demonstrating a configuration example of an oscillation circuit according to a second embodiment of the present invention.

FIG. 7 is a graph showing a result of simulating a relationship between a frequency of a signal input to a base of a transistor in the oscillation circuit of FIG. 6 and the input impedance of the base of the transistor.

FIG. 8 is a circuit diagram of a modified example of the oscillation circuit of FIG. 6.

FIG. 9 is a graph showing a result of simulating a relationship between a frequency of a signal input to a base of a transistor in the oscillation circuit of FIG. 8 and the input impedance of the base of the transistor.

FIG. 10 is a circuit diagram demonstrating a configuration example of an oscillation circuit according to a third embodiment of the present invention.

FIG. 11 is a graph showing a result of simulating a relationship between a frequency of a signal input to a base of a transistor in the oscillation circuit of FIG. 10 and the input impedance of the base of the transistor.

FIG. 12 is a circuit diagram demonstrating a configuration example of an oscillation circuit according to a fourth embodiment of the present invention.

FIG. 13 is a graph showing a result of simulating a relationship between a frequency of a signal input to a base of a transistor in the oscillation circuit of FIG. 12 and the input impedance of the base of the transistor.

FIG. 14 is a graph showing a result of simulating a relationship between a frequency of a signal input to a base of a transistor in a negative resistance input amplifier circuit of FIG. 12 and a reflection gain from the base of the transistor.

FIG. 15 is a circuit diagram demonstrating a configuration example of an oscillation circuit according to a fifth embodiment of the present invention.

FIG. 16 is a graph showing an actual measurement result of phase noise with the oscillation circuit of FIG. 15.

FIG. 17 is a circuit diagram of the configuration of an oscillation circuit of the background art.

FIG. 18 is a graph showing a result of simulating a relationship between a frequency of a signal input to a base of a transistor in a negative resistance input amplifier circuit of FIG. 17 and a reflection gain from the base of the transistor.

Best Mode for Carrying Out the Invention

Hereinafter, embodiments of the present invention will be described with reference to the drawings. The same components are denoted by identical reference numerals, and description thereof is omitted.

(First Embodiment)

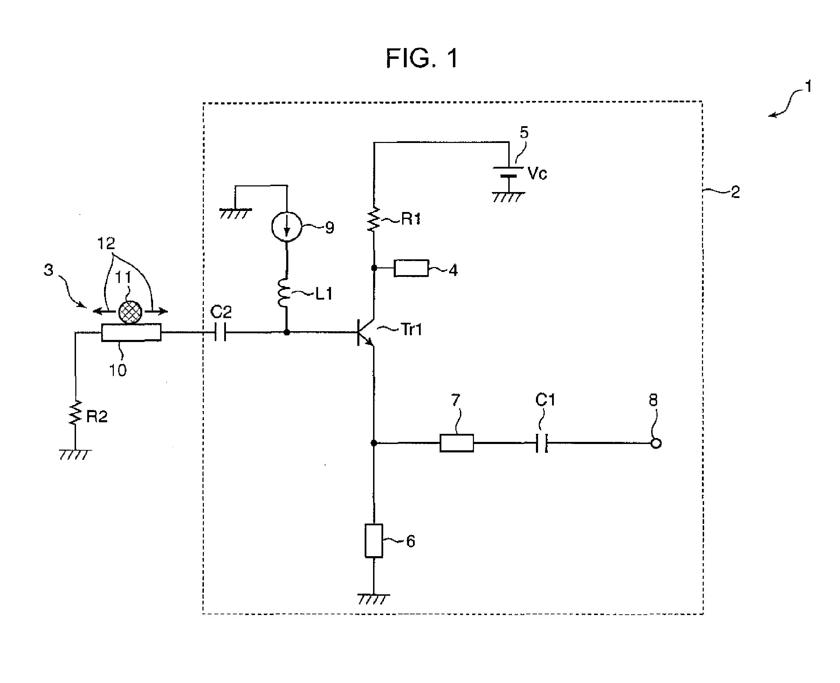

FIG. 1 is a circuit diagram demonstrating a configuration example of an oscillation circuit according to a first embodiment of the present invention. An oscillation circuit 1 of FIG. 1 is a microwave oscillator circuit that generates a microwave, and is composed of a negative resistance input amplifier circuit 2 and a resonator 3. The resonant circuit 2 is configured by coupling a microstrip line 10 to a dielectric resonator 11.

The negative resistance input amplifier circuit 2 includes a microstrip line 4 (first microstrip line) with a length of 1/4 of the wavelength $\lambda$ of the oscillation frequency f of the oscillation circuit 1, which has one end connected to the collector of a transistor Tr1 and the other end open, a DC voltage source 5 for outputting a DC voltage Vc (first voltage), and a resistor R1 connected between the collector of the transistor Tr1 and a voltage output terminal of the DC voltage source 5. Further, an emitter of the transistor Tr1 is grounded through a microstrip line 6 (resonant circuit) having a length of 1/4 of the wavelength $\lambda$ of the target oscillation frequency f. Some of the signals output from the emitter of the transistor Tr1 are output to an external output terminal 8 (signal output) through a microstrip line 7 and a DC-blocking capacitor C1.

The microstrip line 6 has one end grounded with a length of 1/4 of the wavelength $\lambda$ and thus constitutes a resonant circuit whose impedance is highest with respect to a signal of the frequency f.

The microstrip lines 4 and 6 are formed with a conductor pattern on the surface of a printed circuit board, for example. In this case, the length $\lambda/4$ of the microstrip lines 4 and 6 is determined in consideration of a wavelength shortening effect based on an effective dielectric constant. For example, provided that a dielectric constant of the printed circuit board is 3.38 and a dielectric constant of the air is 1.00, an effective dielectric constant of the microstrip lines 4 and 6 is an intermediate value between the dielectric constant of the printed circuit board and the dielectric constant of the air. Considering a wavelength shortening effect based on the effective dielectric constant, $\lambda/4$ with respect to a signal having a frequency of, for example, 6.24 GHz is 8 mm. Thus, the length of each of the microstrip lines 4 and 6 is, for example, 8 mm if the oscillation frequency f is 6.24 GHz.

Further, a bias current is supplied to the base (signal input) of the transistor Tr1 from the constant current source 9 through the coil L1. Further, the base of the transistor Tr1 is grounded through a DC-blocking capacitor C2, a microstrip line 10, and a resistor R2. The microstrip line 10 is coupled to a dielectric resonator 11. The dielectric resonator 11 is a resonator that oscillates with the oscillation frequency f and is made of a ceramic having a dielectric constant of, for example, 20 to 100. For example, a cylindrical resonator with a diameter of 8 mm and a height of 4 mm is used.

Next, operations of the oscillation circuit 1 of FIG. 1 are described. First, the microstrip line 4 has one end open with a length of $\lambda/4$ and thus is grounded with respect to the oscillation frequency f. In other words, the collector of the transistor Tr1 is grounded by the microstrip line 4 with the oscillation frequency f.

The microstrip line 6 has one end grounded with a length of 1/4 of the wavelength $\lambda$. Thus, its impedance is highest with respect to a signal of the frequency f, and it appears open as viewed from the emitter of the transistor Tr1. Hence, the collector of the transistor Tr1 is grounded by the microstrip line 4 with the oscillation frequency f, and the impedance of the emitter of the transistor Tr1 is increased by the microstrip line 6, with the result that the input impedance of the base of the transistor Tr1 becomes negative, and the transistor Tr1 functions as a negative resistance input amplifier circuit.

On the other hand, the microstrip line 6 rapidly lowers the impedance with a frequency shifted from the oscillation frequency f, and the condition that the input impedance of the base of the transistor Tr1 is negative cannot be satisfied. Accordingly, a frequency range where the input impedance of the base of the transistor Tr1 is negative can be narrowed.

Next, a signal applied to the base of the transistor Tr1 is reflected to the microstrip line 10 by the input impedance of the base of the transistor Tr1. More specifically, if the input impedance of the base of the transistor Tr1 is positive, a reflected wave has an amplitude smaller than that of an incident wave. If the input impedance of the base of the transistor Tr1 is negative, a reflected wave has an amplitude larger than that of an incident wave.

Then, the wave reflected by the base of the transistor Tr1 is reflected to the base of the transistor Tr1 by the dielectric resonator 11 again, and the reflected wave reciprocates between the base of the transistor Tr1 and the dielectric resonator 11. A coupling position between the dielectric resonator 11 and the microstrip line 10 is determined such that the phase of the reflected wave from the base of the transistor Tr1 matches the phase of the reflected wave from the dielectric resonator 11 at the base position of the transistor Tr1 (phase shift is a multiple of 360°).

To be specific, the coupling position between the dielectric resonator 11 and the microstrip line 10 is moved in a direction where the distance to the transistor Tr1 is changed as indicated by the arrow 12 to thereby change the phase of the reflected wave from the dielectric resonator 11 such that the phase shift is a multiple of 360° to let the phase of the reflected wave from the base of the transistor Tr1 match the phase of the reflected wave from the dielectric resonator 11 at the base position of the transistor Tr1.

As a result, the reflection gain of the transistor Tr1 is larger than the reflection attenuation in the dielectric resonator 11 with the oscillation frequency f, that is, the input impedance of the base of the transistor Tr1 is negative and its reflection gain is larger than the reflection attenuation in the dielectric resonator 11, with the result that the signal amplitude of the reflected wave is gradually amplified and oscillations occur. Then, some of the signals obtained through the oscillations are output from the external output terminal 8 through the emitter of the transistor Tr1, the microstrip line 7, and the DC-blocking capacitor C1.

On the other hand, with a frequency shifted from the oscillation frequency f, the reflected wave from the base of the transistor Tr1 is not reflected by the dielectric resonator 11 but is absorbed to the resistor R2 and attenuates. As a result, oscillations are suppressed.

Through the above operations, a frequency range where the input impedance of the base of the transistor Tr1 is negative can be narrowed by the microstrip line 6. Thus, the frequency range where the reflection gain of the base of the transistor Tr1 is larger than the reflection attenuation in the dielectric resonator 11 can be reduced, so there is little probability of abnormal oscillation with a frequency other than the frequency f intended by the oscillation circuit 1.

Further, the frequency range where the input impedance of the base of the transistor Tr1 is negative, is narrowed, and abnormal oscillations with a frequency different from the intended oscillation frequency f are suppressed. Thus, even in the case of packaging a circuit substrate having the oscillation circuit 1 integrated therein into a metal case, abnormal oscillations with a resonant frequency the same as that of the case can be suppressed. Further, abnormal oscillations are negligibly induced by coupling between the dielectric resonator 11 and the case etc. Therefore, if the dielectric resonator 11 is moved, its influence on the oscillation frequency is relatively small, so positional adjustment of the dielectric resonator 11 is facilitated. The position of the dielectric resonator 11 can be readily adjusted so as to reduce phase noise with a frequency around the oscillation frequency.

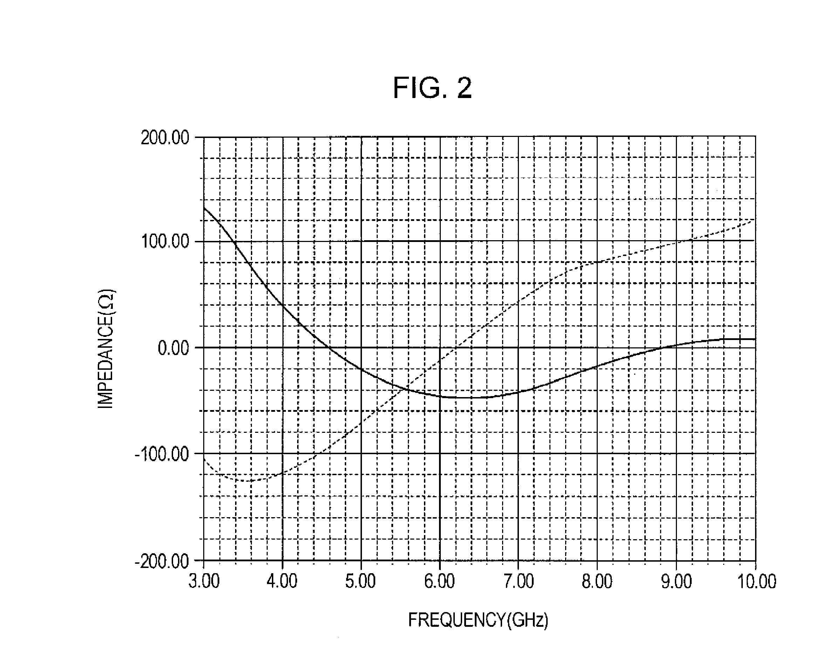

FIG. 2 is a graph showing a result of simulating a relationship between a frequency of a signal input to the base of the transistor Tr1 in the oscillation circuit 1 and the input impedance of the base of the transistor Tr1. The simulation uses 2SC5508 as the transistor Tr1, the microstrip lines 4 and 6 having a width of 1.2 mm and a length of 8 mm, the DC voltage Vc of 3 V, the resistor R1 of 100 Ω, the coil L1 of 100 μH, the microstrip line 7 having a width of 1.2 mm and a length of 12 mm, the capacitors C1 and C2 of 1000 pF, and the constant current source 9 having the output current of 100 μA.

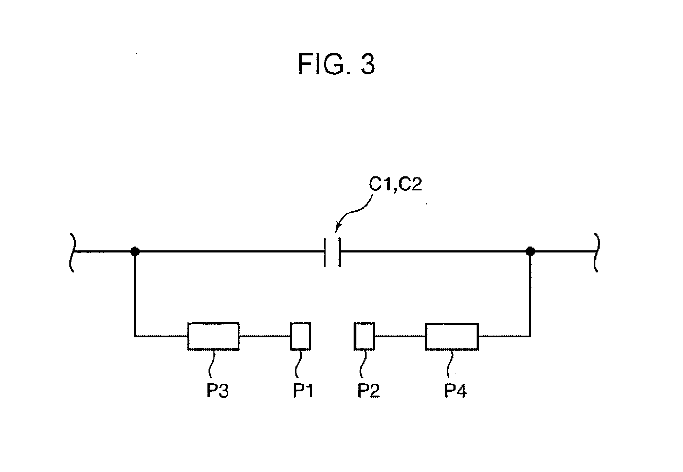

Further, in the simulation, to evaluate an influence of a pad or copper-foil wiring pattern upon actual integration of the capacitors C1 and C2 to a printed wiring board, microstrip lines P1 and P2 that simulate pads used for mounting the capacitors C1 and C3 and microstrip lines P3 and P4 that simulate wiring patterns are used as shown in FIG. 3. The microstrip lines P1, P2, P3, and P4 each have a width of 1.2 mm and a length of 0.5 mm.

In FIG. 2, the horizontal axis represents a frequency of a signal input to the base of the transistor Tr1, the vertical axis represents the input impedance of the base of the transistor Tr1, the solid line represents the real part of the input impedance, and the broken line represents the imaginary part of the input impedance. As shown in FIG. 2, in the oscillation circuit 1 of FIG. 1, the real part of the input impedance of the base of the transistor Tr1, that is, the input impedance of a negative resistance input amplifier circuit 2 composed of the transistor Tr1 becomes negative within a frequency range of 4.57 GHz to 8.79 GHz. It is confirmed that the frequency range where the real part of the input impedance becomes negative can be narrowed compared with that of the oscillation circuit 101 of the background art as shown in FIG. 17.

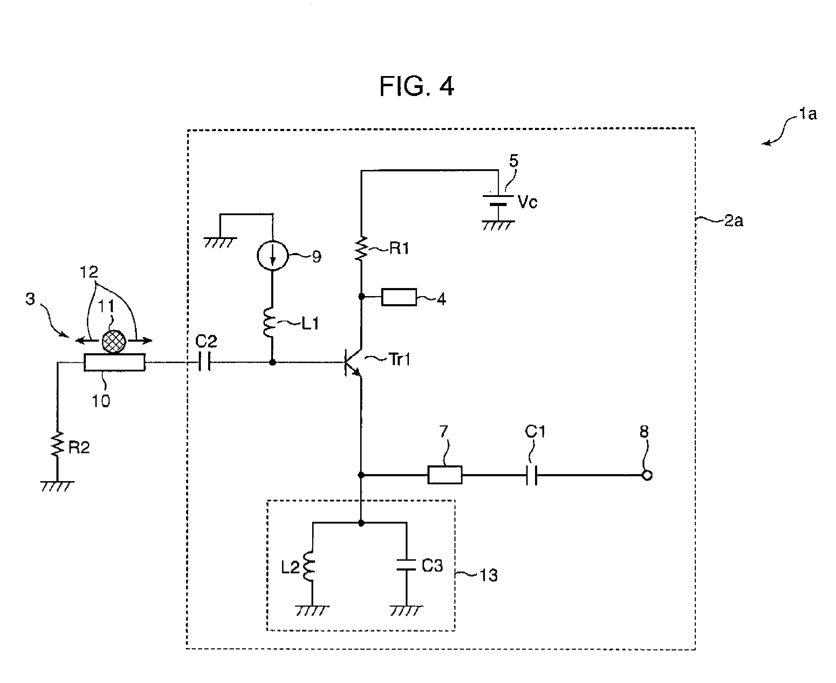

Incidentally, as shown in FIG. 4, a parallel resonant circuit 13 composed of the capacitors C3 and a coil L2 in place of the microstrip line 6 may be used. In this case, an oscillation frequency of the parallel resonant circuit 13 is set to the oscillation frequency f, so the impedance of the parallel resonant circuit 13 rapidly decreases with a frequency shifted from the oscillation frequency f, and the condition that the input impedance of the base of the transistor Tr1 is negative cannot be satisfied. Accordingly, the frequency range where the input impedance of the base of the transistor Tr1 is negative can be narrowed.

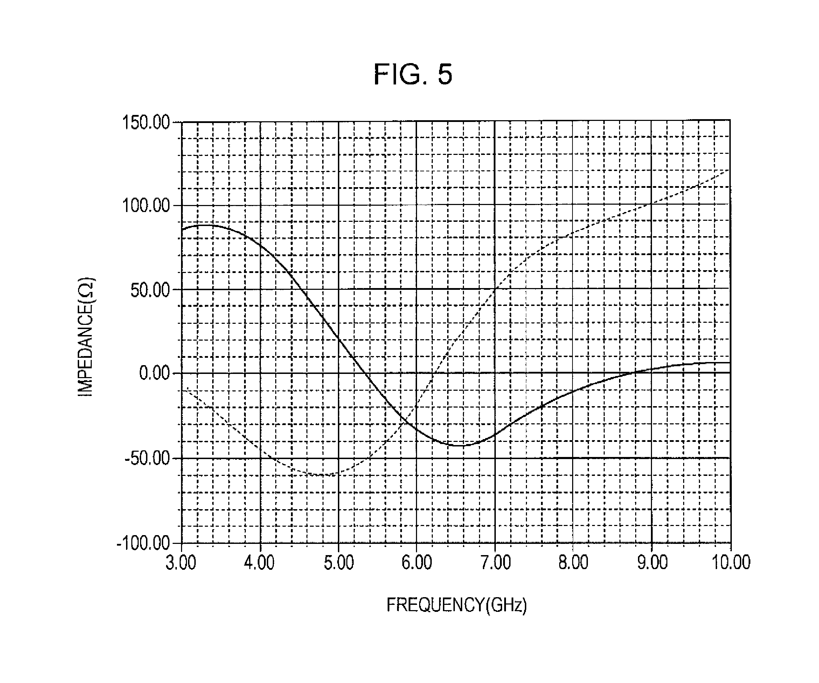

FIG. 5 is a graph showing a result of simulating a relationship between the frequency of a signal input to the base of the transistor Tr1 in an oscillation circuit 1a of FIG. 4 and the input impedance of the base of the transistor Tr1. In the simulation, the capacitance of a capacitor C3 is 1 pF and the inductance of a coil L2 is 0.6 nH. The other circuit constants are the same as those in the simulation condition of FIG. 2, so description thereof is omitted here.

As shown in FIG. 5, in the oscillation circuit 1a of FIG. 4, the real part of the input impedance of the base of the transistor Tr1, that is, the input impedance of a negative resistance input amplifier circuit 2a composed of the transistor Tr1 becomes negative in the frequency range of 5.35 GHz to 8.62 GHz. It is confirmed that the frequency range where the real part of the input impedance becomes negative can be narrowed compared with that of the oscillation circuit 101 of the background art as shown in FIG. 17.

(Second Embodiment)

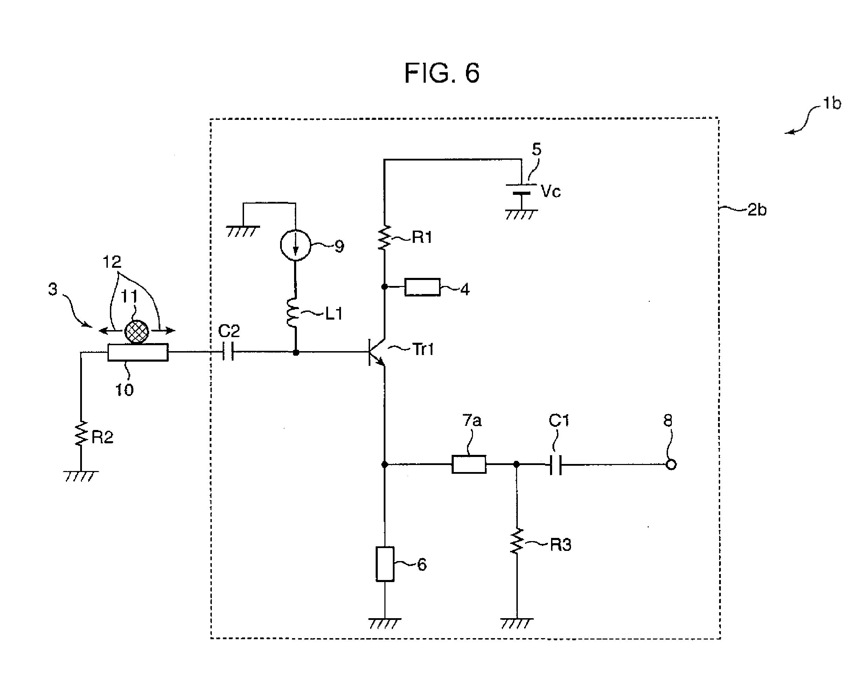

Next, an oscillation circuit according to a second embodiment of the present invention is described. FIG. 6 is a circuit diagram demonstrating a configuration example of the oscillation circuit according to the second embodiment of the present invention. An oscillation circuit 1b of FIG. 6 differs from the oscillation circuit 1 of FIG. 1 in that the oscillation circuit 1b of FIG. 6 is equipped with a microstrip line 7a (second microstrip line) instead of using the microstrip line 7. Further, a node between the microstrip line 7a and the capacitor C1 is grounded (second potential) through a resistor R3 (second resistor).

An intrinsic impedance of the microstrip line 7a is, for example, 50 Ω, and its length is λ/4. Further, a resistance value of the resistor R3 is set to, for example, 50 Ω.

The other components are similar to those of the oscillation circuit 1 of FIG. 1, so description thereof is omitted here. The following description focuses on characteristic operations of this embodiment. First, if a transmission path having a characteristic impedance of 50 Ω is connected to the outside of the external output terminal 8, the impedance viewed from an output terminal of the microstrip line 7a to the external output terminal 8 side is 25 Ω because a characteristic impedance of 50 Ω of the transmission path connected to the external output terminal 8, and a resistance value of 50 Ω of the resistor R3 are parallel-connected. As a result, a resistance of 1/2 of the characteristic impedance of the microstrip line 7a is connected to the output terminal of the microstrip line 7a with the oscillation frequency f, so the impedance viewed from the emitter of the transistor Tr1 to the input terminal of the microstrip line 7a is twice the characteristic impedance of the microstrip line 7a, that is, 100 Ω.

On the other hand, with a frequency different from the oscillation frequency f, the impedance viewed from the emitter of the transistor Tr1 to the input terminal of the microstrip line 7a is 25 Ω because the characteristic impedance of 50 Ω of the transmission path connected to the external output terminal 8, and a resistance value of 50 Ω of the resistor R3 are parallel-connected.

Thus, in the collector-grounded negative resistance input amplifier circuit such as the negative resistance input amplifier circuit 2b, as a load resistance of the emitter increases, the input impedance of the base of the transistor Tr1 is more likely to take a negative value, that is, a negative resistance is easily generated. On the other hand, a negative resistance is hardly generated with a frequency shifted from the oscillation frequency f, so a frequency range where the input impedance of the base of the transistor Tr1 becomes negative can be narrowed.

In this case, a frequency range where the input impedance of the base of the transistor Tr1 in the negative resistance input amplifier circuit 2b is narrowed, making it possible to suppress abnormal oscillations with different frequencies.

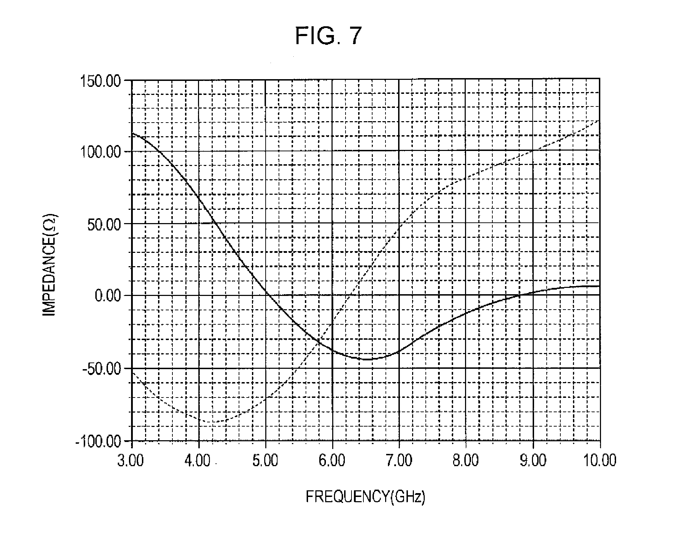

FIG. 7 is a graph showing a result of simulating a relationship between a frequency of a signal input to the base of the transistor Tr1 in the oscillation circuit 1b of FIG. 6 and the input impedance of the base of the transistor Tr1. In the simulation, the microstrip line 7a has the width of 1.2 mm and the length of 8 mm, and the resistor R3 has a resistance value of 50 Ω. The other circuit constants are the same as those in the simulation condition of FIG. 2, so description thereof is omitted here.

As shown in FIG. 7, in the oscillation circuit 1b of FIG. 6, the real part of the input impedance of the base of the transistor Tr1, that is, the input impedance of a negative resistance input amplifier circuit 2b composed of the transistor Tr1 becomes negative in a frequency range of 5.06 GHz to 8.71 GHz. It is confirmed that a frequency range where the real part of the input impedance becomes negative can be narrowed compared as that of the oscillation circuit 101 of the background art as shown in FIG. 17.

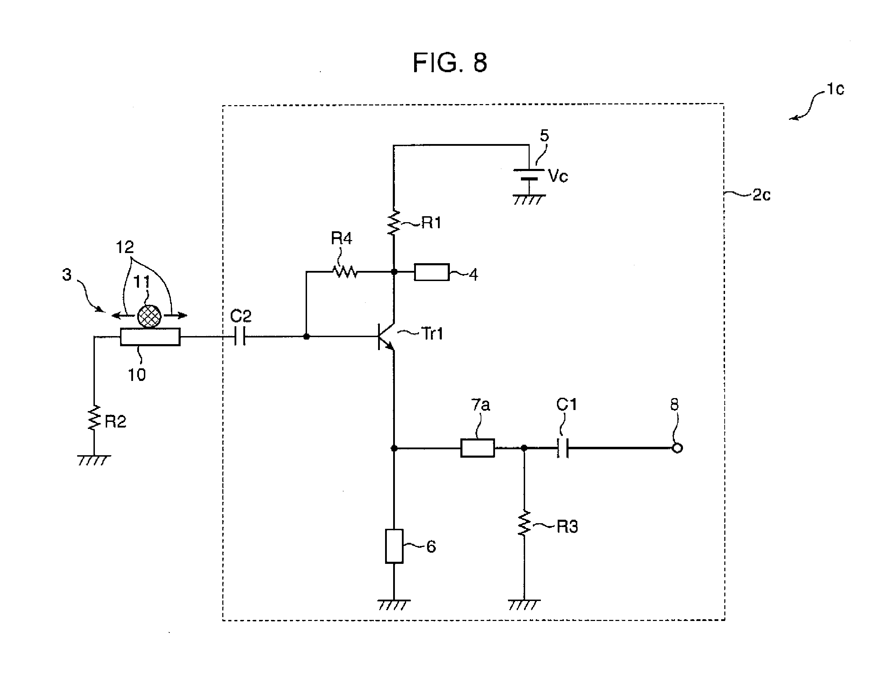

Incidentally, a bias resistor R4 may be connected between the collector and base of the transistor Tr1 in place of the constant current source 9 and the coil L1 like an oscillation circuit 1c of FIG. 8. As a result, the circuit can be simplified. In addition, according to the oscillation circuit 1c, if an amplification factor of the transistor Tr1 increases, which causes a collector current to increase along with environmental change such as increase in ambient temperature, the following negative feedback is realized: the number of times a voltage drops increases at the resistor R4 to lower the collector voltage, so a voltage applied to the resistor R4 is lowered to reduce a base current, resulting in decrease in collector current. Thus, a bias current of the transistor Tr1 can be stabilized.

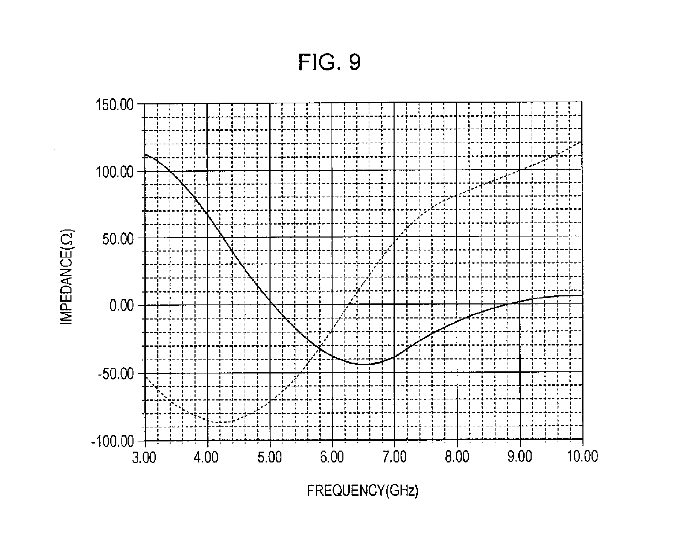

FIG. 9 is a graph showing a result of simulating a relationship between a frequency of a signal input to the base of the transistor Tr1 in the oscillation circuit 1c of FIG. 8 and the input impedance of the base of the transistor Tr1. In the simulation, the resistor R4 has a resistance value of 15 kΩ. The other circuit constants are the same as those in the simulation condition of FIG. 7, so description thereof is omitted here.

As shown in FIG. 9, in the oscillation circuit 1c of FIG. 8, the real part of the input impedance of the base of the transistor Tr1, that is, the input impedance of a negative resistance input amplifier circuit 2c composed of the transistor Tr1 becomes negative in a frequency range of 5.07 GHz to 8.69 GHz. It is confirmed that a frequency range where the real part of the input impedance becomes negative can be narrowed compared as that of the oscillation circuit 101 of the background art as shown in FIG. 17.

(Third Embodiment)

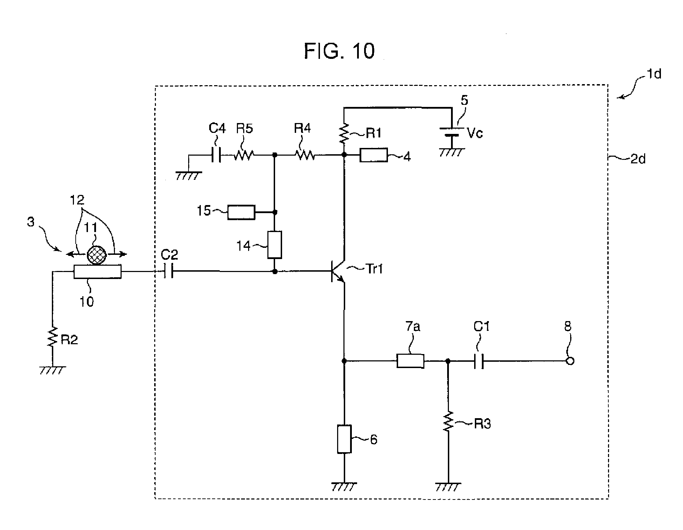

Next, an oscillation circuit according to a third embodiment of the present invention is described. FIG. 10 is a circuit diagram demonstrating a configuration example of the oscillation circuit according to the third embodiment of the present invention. An oscillation circuit 1d of FIG. 10 differs from the oscillation circuit 1c of FIG. 8 in that in the oscillation circuit 1d of FIG. 10, the base of the transistor Tr1 is grounded (second potential) through a microstrip line 14 (fifth microstrip line) having the length of $\lambda/4$, a resistor R5 (third resistor), and a DC-blocking capacitor C4 in a negative resistance input amplifier circuit 2d. Further, a node between the microstrip line 14 and the resistor R5 is connected to the DC voltage source 5 through the resistors R4 and R1, and the base of the transistor Tr1 is set to an intermediate potential (third potential) lower than the collector voltage of the transistor Tr1 and higher than the ground voltage (second potential).

Further provided is a microstrip line 15 (sixth microstrip line) having one end connected to a node between the microstrip line 14 and the resistor R5 and the other end open with the length of $\lambda/4$. Further, the resistor R4 is connected to a node between the microstrip line 14 and the resistor R5, and a bias current is supplied to the base of the transistor Tr1 from the DC voltage source 5 through the resistors R1 and R4, and the microstrip line 14. The microstrip line 14 is desirably narrower than the microstrip line 15.

The other components are similar to those of the oscillation circuit 1c of FIG. 8, so description thereof is omitted here. The following description focuses on characteristic operations of this embodiment. First, since the microstrip line 15 has one end being open with the length of $\lambda/4$ and thus is grounded with respect to the frequency f. Then, the output terminal of the microstrip line 14 is grounded with respect to the oscillation frequency f by the microstrip line 15, so the microstrip line 14 is open as viewed from the base of the transistor Tr1 with the oscillation frequency f, in other words, extremely high impedance is obtained.

On the other hand, with a frequency shifted from the oscillation frequency f, the microstrip line 15 is not grounded with respect to the oscillation frequency f, so the microstrip line 14 is not open with respect to the oscillation frequency f. As a result, the base of the transistor Tr1 is grounded through the microstrip line 14, the resistor R5, and the capacitor C4 with a frequency shifted from the oscillation frequency f. In this case, since the input impedance of the base of the transistor Tr1 and the resistor R5 are parallel-connected as viewed from the resonant circuit 3, negative resistance components of the transistor Tr1 are reduced.

Hence, in the negative resistance input amplifier circuit 2d, negative resistance components of the transistor Tr1 can be reduced with a frequency shifted from the oscillation frequency f, so a frequency range where the input impedance of the base of the transistor Tr1 becomes negative can be narrowed. Further, in the negative resistance input amplifier circuit 2d, the frequency range where the input impedance of the base of the transistor Tr1 becomes negative can be narrowed, so deviation of an oscillation frequency of the oscillation circuit 1d from a target oscillation frequency f can be minimized.

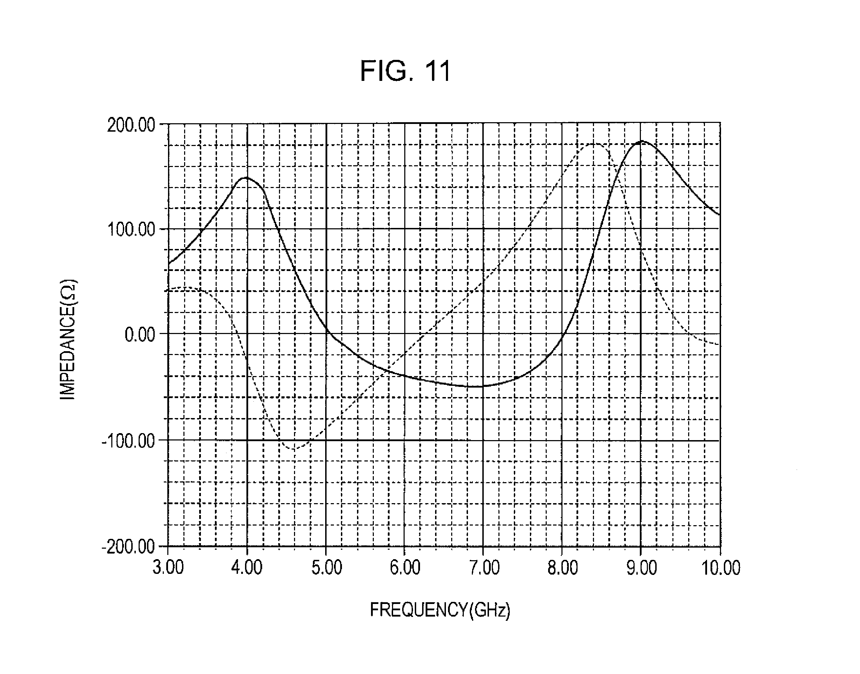

FIG. 11 is a graph showing a result of simulating a relationship between a frequency of a signal input to the base of the transistor Tr1 in the oscillation circuit 1d of FIG. 10 and the input impedance of the base of the transistor Tr1. In the simulation, the microstrip line 14 has the width of 0.1 mm and the length of 8 mm, the microstrip line 15 has the width of 1.2 mm and the length of 8 mm, the resistor R5 has a resistance value of 50 Ω, and the capacitor C4 has a capacitance of 1000 pF. The other circuit constants are the same as those in the simulation condition of FIG. 9, so description thereof is omitted here.

As shown in FIG. 11, in the oscillation circuit 1d of FIG. 10, the real part of the input impedance of the base of the transistor Tr1, that is, the input impedance of the negative resistance input amplifier circuit 2d composed of the transistor Tr1 becomes negative in a frequency range of 5.07 GHz to 8.02 GHz. It is confirmed that a frequency range where the real part of the input impedance becomes negative can be narrowed compared as that of the oscillation circuit 101 of the background art as shown in FIG. 17.

(Fourth Embodiment)

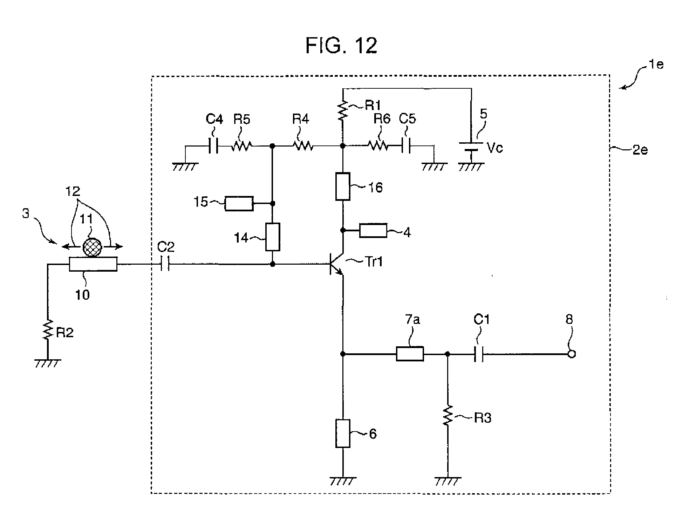

Next, an oscillation circuit according to a fourth embodiment of the present invention is described. FIG. 12 is a circuit diagram demonstrating a configuration example of the oscillation circuit according to the fourth embodiment of the present invention. An oscillation circuit 1e of FIG. 12 differs from the oscillation circuit 1d of FIG. 10 in that in the oscillation circuit 1e of FIG. 12, a microstrip line 16 (ninth microstrip line) having the length of $\lambda/4$ is inserted between a node between the microstrip line 4 and the collector of the transistor Tr1 and the resistor R1. Further, a node between the resistor R1 and the microstrip line 16 is grounded through the resistor R6 and the capacitor C5.

Then, a combined resistance of the resistors R1 and R6 is set to a resistance value equal to a characteristic impedance of the microstrip line 16 from the collector of the transistor Tr1 to the resistor R1. For example, if a characteristic impedance of a wiring pattern is 50 Ω, and the resistor R1 has a resistance value of 100 Ω, the resistor R6 is set to 100 Ω, and a resistance value of the parallel-connected resistors R1 and R6 is equal to 50 Ω as a characteristic impedance of the wiring pattern. Further, the capacitor C5 is set to a capacitance that realizes a low impedance in a wide frequency range including the frequency range where the transistor Tr1 takes a negative resistance.

Incidentally, a resistance value of the resistor R1 may be set to 50 Ω as a characteristic impedance of the wiring pattern instead of using the resistor R6 and the capacitor C5. In the oscillation circuit 1e of FIG. 12, a combined resistance of the resistors R1 and R6 corresponds to a first resistance specified in the scope of claims.

The other components are similar to those of the oscillation circuit 1d of FIG. 10, so description thereof is omitted here. The following description focuses on characteristic operations of this embodiment. First, since the microstrip line 4 has one end being open with the length of $\lambda/4$ and thus is grounded with respect to the frequency f in the oscillation circuit 1e. That is, the collector of the transistor Tr1 is grounded with respect to the oscillation frequency f by the microstrip line 4. Further, the microstrip line 16 serves as the impedance converter with respect to the oscillation frequency f. For example, if the microstrip line 16 has the width of 0.1 mm and the length of 8 mm, the impedance of the microstrip line 16 is 140 Ω with respect to a signal of 6.24 GHz. Hence, the microstrip line 16 appears to have the impedance of about 400 Ω as viewed from the collector of the transistor Tr1 because $Z = (140)^2/50 = 400$ Ω.

Then, the collector of the transistor Tr1 is grounded with respect to the oscillation frequency f by the microstrip line 4, and in addition, the impedance of a signal path extending to the DC voltage source 5 is converted to the microstrip line 16, so an influence of the DC voltage source 5 on the collector voltage of the transistor Tr1 is suppressed, and the ground stage of the collector of the transistor Tr1 is improved.

If the ground state of the collector of the transistor Tr1 is improved with respect to the oscillation frequency f, the input impedance of the base of the transistor Tr1 is more likely to take a negative value in a collector-grounded negative resistance input amplifier circuit 2e, so the oscillation circuit 1e can oscillate with a target oscillation frequency f.

Further, as for a frequency slightly deviate from the oscillation frequency f, the effect of collector-grounded transistor Tr1 based on the microstrip line 4 is reduced, and the collector is grounded with the impedance of 400 Ω converted by the microstrip line 16, with the result that the collector-grounding conditions are not met, and thus a frequency range where the input impedance in the transistor Tr1 of the negative resistance input amplifier circuit 2e becomes negative is narrowed, and the oscillation circuit 1e can oscillate with a frequency shifted from the oscillation frequency f.

Incidentally, in the negative resistance input amplifier circuit 2e, the microstrip line 16 may be shortcircuited instead of using the microstrip line 16. In the negative resistance input amplifier circuit 2e, the resistor R6 or the capacitor C5 may be omitted.

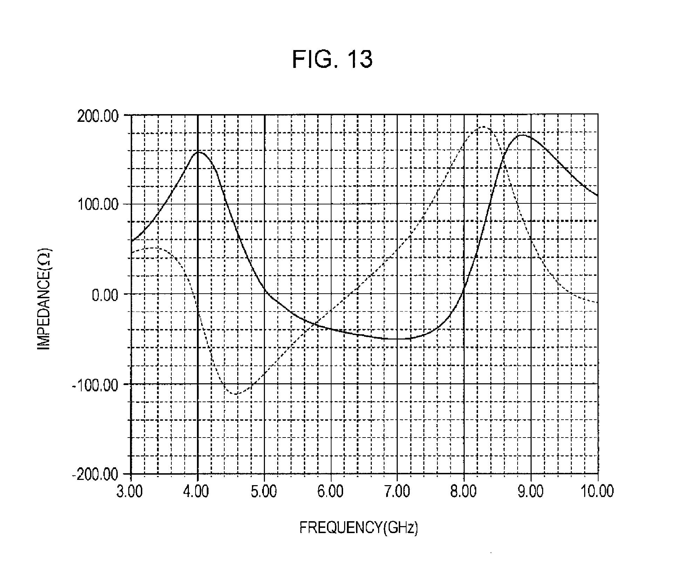

FIG. 13 is a graph showing a result of simulating a relationship between a frequency of a signal input to the base of the transistor Tr1 in the oscillation circuit 1e of FIG. 12 and the input impedance of the base of the transistor Tr1. In the simulation, the microstrip line 16 has the width of 0.1 mm and the length of 8 mm, the resistor R6 has a resistance value of 100 Ω, and the capacitor C5 has a capacitance value of 100 pF. The other circuit constants are the same as those in the simulation condition of FIG. 111, so description thereof is omitted here.

As shown in FIG. 13, in the oscillation circuit 1e of FIG. 12, the real part of the input impedance of the base of the transistor Tr1, that is, the input impedance of a negative resistance input amplifier circuit 2e composed of the transistor Tr1 becomes negative in a frequency range of 5.07 GHz to 7.98 GHz. It is confirmed that a frequency range where the real part of the input impedance becomes negative can be narrowed compared as that of the oscillation circuit 101 of the background art as shown in FIG. 17.

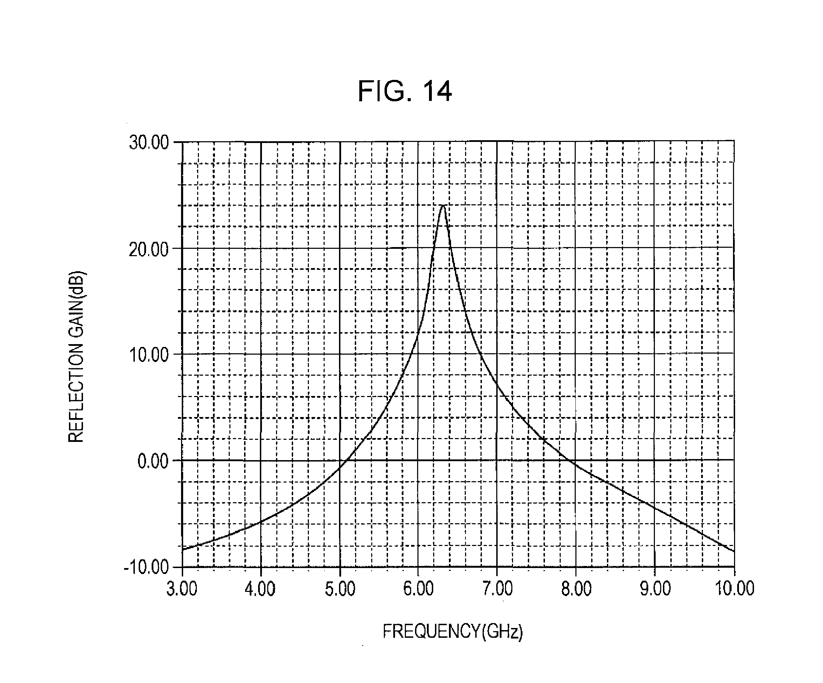

FIG. 14 is a graph showing a result of simulating a relationship between a frequency of a signal input to the base of the transistor Tr1 in a negative resistance input amplifier circuit 2e of FIG. 12 and a reflection gain from the base of the transistor. The simulation conditions are similar to those of the graph of FIG. 13. As shown in FIG. 14, a reflection gain from the base of the transistor Tr1 is positive in a frequency range of 5.07 GHz to 7.98 GHz. In this frequency range, the circuit might oscillate. Further, with the center frequency of 6.31 GHz, a reflection gain of about 24 dB is obtained; if a signal of this frequency is input to the base of the transistor Tr1, about 20-fold reflection wave is generated.

(Fifth Embodiment)

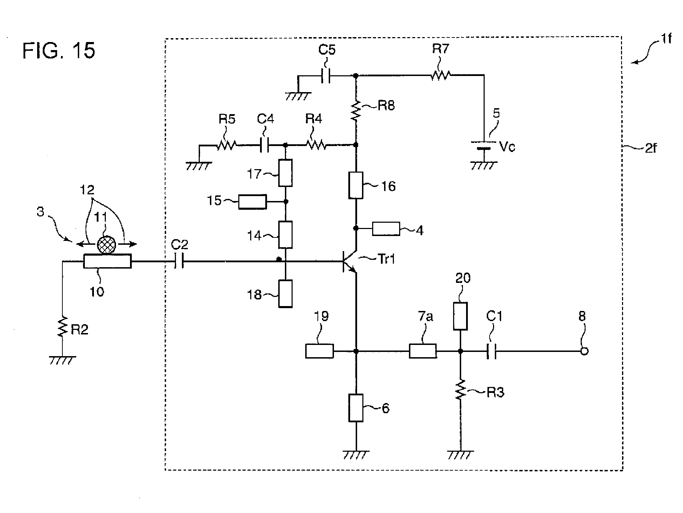

Next, an oscillation circuit according to a fifth embodiment of the present invention is described. FIG. 15 is a circuit diagram demonstrating a configuration example of the oscillation circuit according to the fifth embodiment of the present invention. An oscillation circuit 1f of FIG. 15 differs from the oscillation circuit 1e of FIG. 12 in that in the oscillation circuit 1f of FIG. 15, the resistor R5 and the capacitor C4 are exchanged in position in the negative resistance input amplifier circuit 2f, and a microstrip line 17 (seventh microstrip line) having the length of λ/4 is provided between the capacitor C4 and a node between the microstrip line 14 and the microstrip line 15. A characteristic impedance of the microstrip line 17 is set to, for example, 110 Ω. The capacitor C4 is set to a capacitance that realizes extremely low impedance with respect to the oscillation frequency f. Further, the microstrip line 17 is provided between the resistor R5 and a node between the microstrip line 14 and the microstrip line 15.

Further provided is a microstrip line 18 (eighth microstrip line) having one end open and the other end connected to the base of the transistor Tr1. The length of the microstrip line 18 is set to make the phase of a signal input to the base of the transistor Tr1 matched with the phase of a reflection wave from the base of the transistor Tr1. Further provided is a microstrip line 19 (third microstrip line) having one end open and the other end connected to the emitter of the transistor Tr1. The length of the microstrip line 19 is set such that the phase that realizes a peak negative resistance of the transistor Tr1 matches the oscillation frequency f. Further provided is a microstrip line 20 (fourth microstrip line) has one end connected to a node between the microstrip line 7a and the resistor R3 and the other end open. The length of the microstrip line 20 is determined such that the phase that realizes a peak negative resistance of the transistor Tr1 matches the oscillation frequency f.

Characteristic impedance values of the microstrip lines 18, 19, and 20 are set to, for example, 50 Ω. Further, the collector of the transistor Tr1 is connected to the DC voltage source 5 through the microstrip line 16, the resistor R8, and the resistor R7. A node between the resistors R8 and R7 is grounded through the capacitor C5. The resistor R8 has a resistance value of, for example, 50 Ω. The resistor R7 has a resistance value of, for example, 10 Ω.

The other components are the same as that of the oscillation circuit 1e of FIG. 12, so description thereof is omitted here. The following description focuses on characteristic operations of this embodiment. First, in the negative resistance input amplifier circuit 2f, provided that Z2 represents the impedance of subsequent circuits of the microstrip line 17 such as the capacitor C4 and the resistor R5, and Zi represents a characteristic impedance of the microstrip line 17, the impedance Z1 viewed from the input terminal side (microstrip line 14 side) of the microstrip line 17 is derived from the following Expression (1):

$$Z1 = Zi \times Zi/Z2 \ldots (1)$$

where Z2 is mainly determined by a resistance value of the resistor R5. If the resistor R5 has a resistance value of, for example, 50 Ω, and the characteristic impedance Zi of the microstrip line 17 is 110 Ω, Z1 = 110 x 110/50 = 242(Ω).

On the other hand, the microstrip line 15 has one end open with the length of λ/4 and thus is grounded with the oscillation frequency f, that is, has an extremely low impedance. Then, the impedance Z1 of the microstrip line 17 viewed from the microstrip line 14 is extremely high with respect to the impedance of the microstrip line 15. An influence of the impedance Z1 is suppressed to thereby enhance an effect that the output terminal of the microstrip line 14 is grounded with respect to the oscillation frequency f with the microstrip line 15.

If the effect of grounding the output terminal of the microstrip line 14 is enhanced, the impedance of the microstrip line 14 viewed from the base of the transistor Tr1 is further increased, making it possible to prevent negative resistance components of the transistor Tr1 from decreasing due to an influence of subsequent circuits of the microstrip line 17 at the oscillation frequency f, and to stabilize the oscillating operation of the oscillation circuit 1f with the oscillation frequency f.

The microstrip line 18 attains an effect similar to an effect of grounding with a capacitor having a capacitance of about 0.01 pF at the oscillation frequency f if its length corresponds to 1° in terms of electrical angle, for example, of the oscillation frequency f. Accordingly, the length of the microstrip line 18 is adjusted to thereby adjust the phase angel of a reflected wave applied to the base of the transistor Tr1. Hence, the length of the microstrip line 18 is set such that the phase of a signal input to the base of the transistor Tr1 matches the phase of a reflected wave from the base of the transistor Tr1 at the base position to thereby appropriately amplify a signal amplitude between the dielectric resonator 11 and the transistor Tr1, and stabilize oscillating operations of the oscillation circuit 1f.

The microstrip lines 19 and 20 attain an effect similar to an effect of grounding with a capacitor having a capacitance of about 0.3 pF at the oscillation frequency f if its length corresponds to 30° in terms of electrical angle, for example, of the oscillation frequency f. In this way, a microstrip line having the length shorter than λ/4, that is, 90° serves as a capacitor, so the length of the microstrip lines 19 and 20 is finely adjusted to finely adjust the impedance of the emitter of the transistor Tr1. Accordingly, length of the microstrip lines 19 and 20 is set such that the phase that realizes a peak negative resistance of the transistor Tr1 matches the oscillation frequency f. As a result, the oscillation circuit can oscillate at an oscillation frequency f.

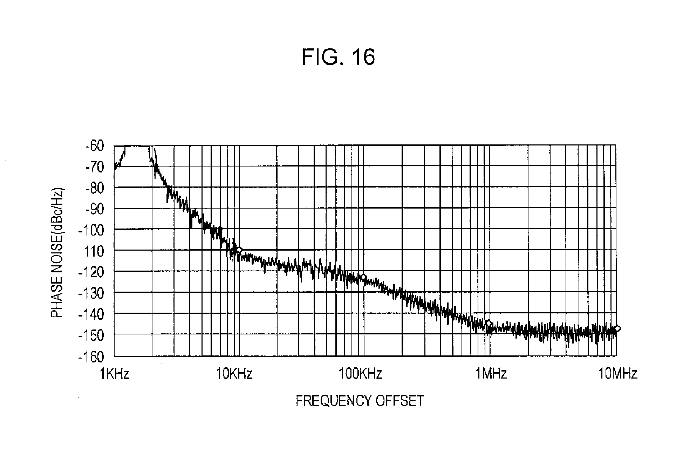

FIG. 16 is a graph showing an actual measurement result of phase noise in the case of an oscillator is actually configured using the oscillation circuit 1f of FIG. 15 and the circuit is operating. In the graph of FIG. 16, the horizontal axis represents frequency offset, that is, an offset from the oscillation frequency in the oscillation circuit, and the vertical axis represents a phase noise level. According to the measurement result, extremely low phase noise characteristics can be obtained with the oscillation circuit 1f; if a frequency offset is 10 kHz, a phase noise level if -111 dBc/Hz, and if a frequency offset is 100 kHz, a phase noise level is -124 dBc/Hz.

Further, the inventors of the subject application have measured phase noise of available typical microwave oscillators by experiment. The measurement result reveals that a phase noise level is -105 dBc/Hz with a frequency offset of 100 kHz with HMC358MS available from Hittite Microwave Corporation, a phase noise level is -115 dBc/Hz with a frequency offset of 100 kHz with V965ME04 available from Z-communications Inc., and a phase noise level is -110 to -119 dBc/Hz with a frequency offset of 100 kHz with GDV307KS available from YOKOWO-UBE GIGA DEVICES CO., LTD, and as compared with these available microwave oscillators, the oscillation circuit 1f of FIG. 15 can considerably reduce a phase noise. Incidentally, in the above example, the transistor Tr1 is a bipolar transistor. However, a field effect transistor (FET) may be used, and a gate, a source, and a drain may be used in place of the base, the emitter, and the collector, respectively. Further, the length of the microstrip line is influenced by electrical conditions upon actual assembly of an oscillator such as characteristics of the transistor Tr1 or layout of components and thus desirably is finely adjusted to obtain the optimum negative resistance with a target oscillation frequency.

Further, the DC voltage Vc is used as the first potential and the ground potential is used as the second potential within the scope of claims, but the first potential may be a ground potential and the second potential may be a negative potential lower than the first potential.

As described above, a negative resistance input amplifier circuit according to the present invention includes: a transistor; a first microstrip line having a length of 1/4 of a wavelength of a signal having a predetermined frequency, and having one end connected to a collector of the transistor and the other end open; a first resistor connected between the collector of the transistor and a preset first potential; and a resonant circuit connected between an emitter of the transistor and a second potential lower than the first potential, and having the impedance that is highest with respect to a signal of the frequency, in which a base of the transistor is used as a signal input for receiving a signal from the outside, and the emitter of the transistor is used as a signal output for outputting a signal to the outside.

Further, preferably, the emitter of the transistor is further connected to the second potential through a serial circuit composed of a second microstrip line and a second resistor, and a node between the second microstrip line and the second resistor is used as the signal output.

Further, preferably, the negative resistance input amplifier circuit further includes: a third microstrip line having one end open and the other end connected to the emitter of the transistor, in which a length of the third microstrip line is determined such that a frequency at which a negative resistance of the transistor peaks matches the frequency.

Further, preferably, the negative resistance input amplifier circuit further includes: a fourth microstrip line having one end connected to a node between the second microstrip line and the second resistor and the other end open, in which a length of the fourth microstrip line is determined such that a frequency at which a negative resistance of the transistor peaks matches the frequency.

Further, preferably, the base of the transistor is connected to a third potential that is lower than the first potential and higher than the second potential, through a serial circuit composed of a fifth microstrip line having a length of 1/4 of a wavelength of the signal having the frequency and a third resistor, and the amplifier further includes a sixth microstrip line having one end connected to a node between the fifth microstrip line and the third resistor and the other end open, and having a length of 1/4 of a frequency of the signal having the frequency.

Further, preferably, the negative resistance input amplifier circuit further includes: a seventh microstrip line having a length of 1/4 of a frequency of the signal having the frequency and provided between the third resistor and a node between the fifth microstrip line and the sixth microstrip line.

Further, preferably, the negative resistance input amplifier circuit further includes: an eighth microstrip line having one end open and the other end connected to the base of the transistor, in which a length of the eighth microstrip line is determined such that the phase of a signal input to the base of the transistor matches the phase of a reflected wave from the base of the transistor.

Further, preferably, the negative resistance input amplifier circuit further includes: a ninth microstrip line having a length of 1/4 of a frequency of the signal having the frequency and provided between the first resistor and a node between the first microstrip line and the collector of the transistor,

Further, preferably, the transistor is a field effect transistor, and a gate is used in place of the base, a source is used in place of the emitter, and a drain is used in place of the collector.

According to the thus-configured negative reference input amplifier circuit, the collector of the transistor is grounded with respect to a predetermined frequency by the first microstrip line, and the impedance of the emitter of the transistor is maximized with respect to the frequency by the resonant circuit, so the collector of the transistor is grounded and the impedance of the emitter is maximized, whereby a frequency range where the input impedance of the base of the transistor becomes negative can be narrowed.

In an oscillation circuit according to the present invention, a resonator that reflects a signal of a predetermined frequency is connected to a signal input in a negative resistance input amplifier circuit, and the negative resistance input amplifier circuit is the above negative resistance input amplifier circuit, and the predetermined frequency is a frequency in the above negative resistance input amplifier circuit.

According to the thus-configured oscillation circuit using the negative resistance input amplifier circuit, a signal of the predetermined frequency is reflected by the oscillator to the base of the transistor, and within a frequency range where the input impedance of the base of the transistor is negative, the signal is repeatedly reflected and thus amplified and oscillated, so the frequency range where the input impedance is negative is reduced by the negative resistance input amplifier circuit to thereby suppress abnormal oscillations with a frequency other than a desired frequency.

**Claims**

1. A negative resistance input amplifier circuit, comprising:

   a transistor;
   a first microstrip line having a length of 1/4 of a wavelength of a signal having a predetermined frequency, and having one end connected to a collector of the transistor and the other end open;
   a first resistor connected between the collector of the transistor and a preset first potential; and
   a resonant circuit connected between an emitter of the transistor and a second potential lower than the first potential, and having the impedance that is highest with respect to the signal having the predetermined frequency,
   wherein a base of the transistor is used as a signal input for receiving a signal from the outside, and the emitter of the transistor is used as a signal output for outputting a signal to the outside.

2. The negative resistance input amplifier circuit according to claim 1, wherein the emitter of the transistor is further connected to the second potential through a serial circuit composed of a second microstrip line and a second resistor, and
   a node between the second microstrip line and the second resistor is used as the signal output.

3. The negative resistance input amplifier circuit according to claim 1, further comprising:

   a third microstrip line having one end open and the other end connected to the emitter of the transistor,
   wherein the length of the third microstrip line is determined such that a frequency at which a negative resistance of the transistor peaks matches the predetermined frequency of the signal.

4. The negative resistance input amplifier circuit according to claim 1, further comprising:

   a fourth microstrip line having one end connected to a node between the second microstrip line and the second resistor and the other end open,
   wherein a length of the fourth microstrip line is determined such that a frequency at which a negative resistance of the transistor peaks matches the predetermined frequency of the signal.

5. The negative resistance input amplifier circuit according to claim 1, wherein the base of the transistor is connected to a third potential that is lower than the first potential and higher than the second potential, through a serial circuit composed of a fifth microstrip line having a length of 1/4 of a wavelength of the signal having the predetermined frequency and a third resistor, and
   the amplifier further includes a sixth microstrip line having one end connected to a node between the fifth microstrip line and the third resistor and the other end open, and having a length of 1/4 of the wavelength of the signal having the predetermined frequency.

6. The negative resistance input amplifier circuit according to claim 5, further comprising: a seventh microstrip line having a length of 1/4 of the wavelength of the signal having the predetermined frequency and provided between the third resistor and a node between the fifth microstrip line and the sixth microstrip line.

7. The negative resistance input amplifier circuit according to claim 1, further comprising: an eighth microstrip line having one end open and the other end connected to the base of the transistor,
   wherein a length of the eighth microstrip line is determined such that the phase of a signal input to the base of the transistor matches the phase of a wave reflected from the base of the transistor.

8. The negative resistance input amplifier circuit according to claim 1, further comprising: a ninth microstrip line having a length of 1/4 of the wavelength of the signal having the predetermined frequency and provided between the first resistor and a node between the first microstrip line and the collector of the transistor.

9. The negative resistance input amplifier circuit according to claim 1, wherein the transistor is a field effect transistor, and a gate is used in place of the base, a source is used in place of the emitter, and a drain is used in place of the collector.

10. An oscillation circuit, wherein a resonator that reflects a signal of a predetermined frequency is connected to a signal input in a negative resistance input amplifier circuit, and
the negative resistance input amplifier circuit is the negative resistance input amplifier circuit according to claim 1, and the predetermined frequency is a frequency in the negative resistance input amplifier circuit according to claim 1.

FIG. 1

# FIG. 2

EP 1 852 969 A1

FIG. 3

C1,C2

P3          P1     P2          P4

# FIG. 4

EP 1 852 969 A1

FIG. 5

EP 1 852 969 A1

# FIG. 6

EP 1 852 969 A1

# FIG. 7

# FIG. 8

EP 1 852 969 A1

## FIG. 9

## FIG. 10

# FIG. 11

EP 1 852 969 A1

## FIG. 12

## FIG. 13

FIG. 14

FIG. 15

FIG. 16

FIG. 17

FIG. 18

## INTERNATIONAL SEARCH REPORT

| International application No. |
| --- |
| PCT/JP2006/301742 |

**A. CLASSIFICATION OF SUBJECT MATTER**
*H03B5/18*(2006.01)

According to International Patent Classification (IPC) or to both national classification and IPC

**B. FIELDS SEARCHED**

Minimum documentation searched (classification system followed by classification symbols)
H03B5/00-5/28

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 57-026902 A (Hitachi, Ltd.),<br>13 February, 1982 (13.02.82),<br>Full text; all drawings<br>(Family: none) | 1,3,9,10<br>2,4<br>5-8 |
| X<br>Y<br>A | JP 63-314003 A (Murata Mfg. Co., Ltd.),<br>22 December, 1988 (22.12.88),<br>Full text; all drawings<br>(Family: none) | 1,2,4,9,10<br>3<br>5-8 |
| Y | JP 6-318819 A (Taiyo Yuden Co., Ltd.),<br>15 November, 1994 (15.11.94),<br>Abstract; Claims 1, 2; Fig. 1<br>(Family: none) | 3 |

☒ Further documents are listed in the continuation of Box C.  ☐ See patent family annex.

| | |
| --- | --- |
| *    Special categories of cited documents:<br>"A"    document defining the general state of the art which is not considered   to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search<br>02 May, 2006 (02.05.06) | Date of mailing of the international search report<br>16 May, 2006 (16.05.06) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2006/301742 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 1-190010 A (Matsushita Electric Industrial Co., Ltd.), 31 July, 1989 (31.07.89), Full text; all drawings (Family: none) | 7 |
| A | JP 2001-292029 A (Matsushita Electric Industrial Co., Ltd.), 19 October, 2001 (19.10.01), Full text; all drawings & EP 1154561 B1 & US 6987960 B2 & CN 1317883 A & DE 60107751 T2 | 1-10 |

Form PCT/ISA/210 (continuation of second sheet) (April 2005)

**EP 1 852 969 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004007125 A